Europäisches Patentamt

(19) European Patent Office

Office européen des brevets

(11) Publication number: **0 216 935 B1**

## (12) EUROPEAN PATENT SPECIFICATION

(45) Date of publication of patent specification:
20.02.91 Bulletin 91/08

(51) Int. Cl.⁵: **H01L 31/0203**

(21) Application number: 86902002.4

(22) Date of filing: 06.03.86

(86) International application number:
PCT/JP86/00115

(87) International publication number:
WO 86/05324 12.09.86 Gazette 86/20

(54) **SOLID-STATE IMAGE PICKUP DEVICE AND METHOD OF MANUFACTURING THE SAME.**

(30) Priority: 08.03.85 JP 46036/85

(43) Date of publication of application:
08.04.87 Bulletin 87/15

(45) Publication of the grant of the patent:
20.02.91 Bulletin 91/08

(84) Designated Contracting States:
AT BE CH DE FR GB IT LI NL SE

(56) References cited:
US-A- 4 001 863
US-A- 4 224 081
US-A- 4 231 807
US-A- 4 241 493
Patents Abstracts of Japan,vol. 5, no. 34,
(E-48)(706), 4 March 1981 & JP-A-55159678
Patents Abstracts of Japan,vol. 7, no. 123,
(E-178)(1268), 27 May 1983 & JP-A-5840870

(73) Proprietor: OLYMPUS OPTICAL CO., LTD.
43-2, 2-chome, Hatagaya Shibuya-ku
Tokyo 151 (JP)

(72) Inventor: OGIU, Hisao Cohpo Musashisuehiro
No. 203
2-3-6, Suehiromachi Oume-shi
Tokyo 198 (JP)
Inventor: TAKAGI, Takeji 3092-1, Aiharamachi
Machida-shi
Tokyo 194-03 (JP)
Inventor: TANAKA, Toshio Cohpo Fuji A-301
6-5, Nishinanokamachi Aizuwakamatsu-shi
Fukushima-ken 965 (JP)

(74) Representative: Lins, Edgar, Dipl.-Phys. et al
Patentanwälte Gramm + Lins
Theodor-Heuss-Strasse 2
D-3300 Braunschweig (DE)

## Description

The present invention relates to a solid-state image pickup device used in, for example, an endoscope, and a method of manufacturing the same.

A conventional solid-state image pickup device is disclosed in Japanese Patent Disclosure No. 59-18679. A semiconductor chip is fixed in a package, and a front opening of the package is covered with a transparent cap member to protect an image pickup surface of the semiconductor chip.

A mount portion is formed on a periphery of the package. The separate cap member is mounted on the mount portion. The resultant solid-state image pickup device inevitably has a large outer diameter along a direction parallel to the image pickup surface. For this reason, when such a device is built into an apparatus such as the insertion portion of an endoscope, which requires a compact or small-diameter arrangement, the insertion portion has a larger diameter, causing physical pain to a patient.

In US-A-4,001,863 there is disclosed a photoconductor element which is made from a substrate and a photoconductive layer formed thereon. Ohmic electrodes are arranged on the photoconductive layer and connected with lead wires extending through preformed openings provided in the substrate. The whole arrangement consisting of substrate, photoconductive layer and electrodes is surrounded by a thin epoxy layer and an outer layer consisting of polypropylene. The layers completely surround the whole arrangement.

Patent's abstracts of Japan, Vol. 5, No. 34 (E-48) (706) of March 4, 1989 discloses a charge coupled device (CCD) which is stuck on the surface of a ceramic package with adhesives. The surface of CCD is covered with a transparent adhesive so as to fix a glass substrate having parallel surfaces on CCD. The incident surface of the glass substrate is smaller than the surface of CCD and much smaller than the surface of the ceramic package. The gap between the package and the glass substrate is filled with mold material so as to protect bonding wires leading from the CCD to the package. Numerous different materials have to be used.

It is the object of the present invention to provide a solidstate image pickup device, dimensions of which can be reduced along a direction parallel to the image pickup surface, and a method of easily and systematically manufacturing the same.

According to the present invention this object is accomplished by a solid-state image pickup device as decribed in claims 1 or 2.

Furthermore, the object is accomplished by methods as described in claims 4 and 7.

The advantages provided by the invention and preferred embodiments are described with reference to the accompaning drawing, in which :

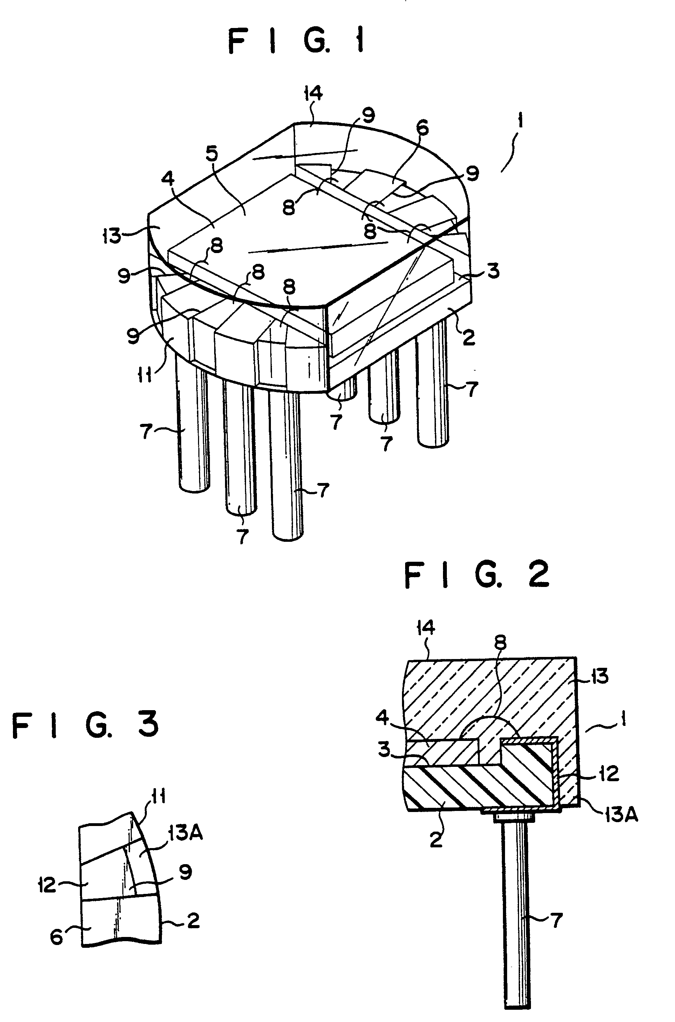

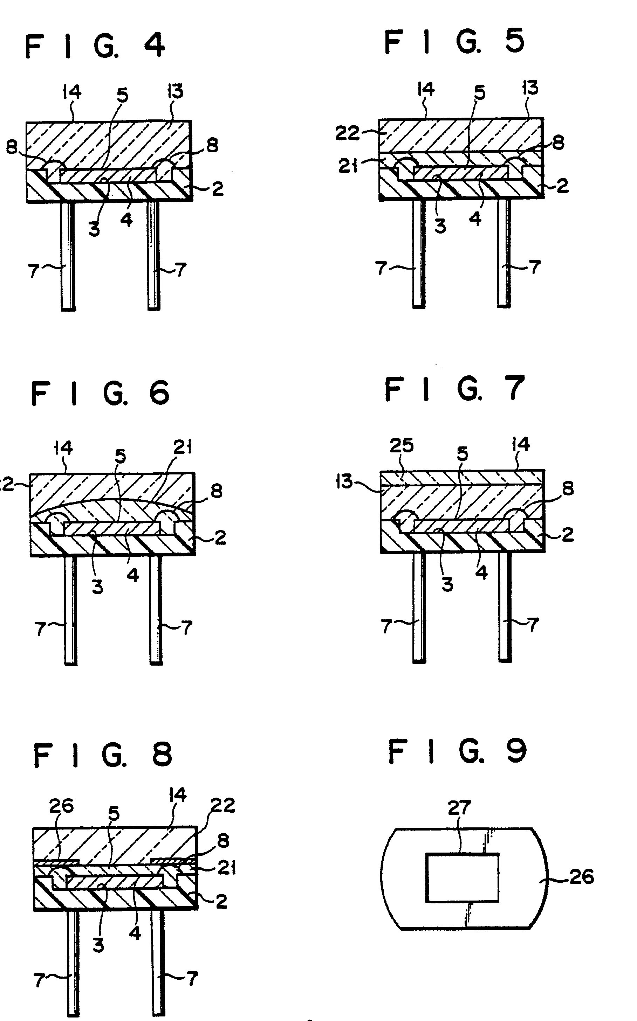

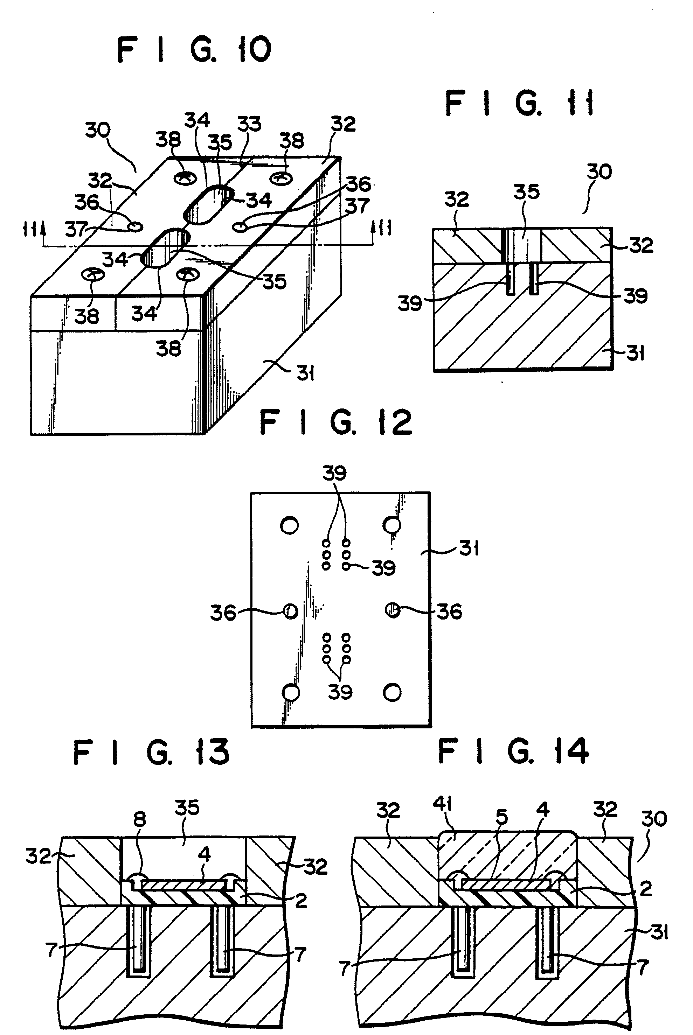

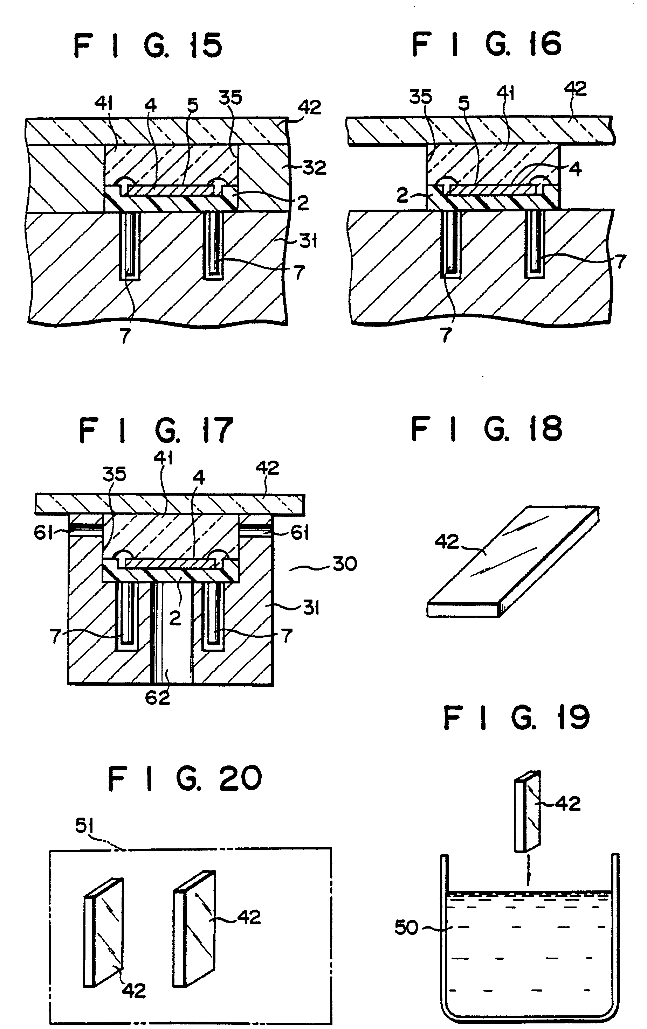

Fig. 1 is a perspective view of a solid-state image pickup device conceived by the inventor, Fig. 2 is a side sectional view of a guide groove portion of the device of Fig. 1, Fig. 3 is a plan view of the guide groove portion of Fig. 2, Fig. 4 is a sectional view showing a basic structure of the solid-state image pickup device according to the embodiment of Fig. 1, Fig. 5 is a sectional view showing a basic structure of a solid-state image pickup device according to a first embodiment of the present invention, Fig. 6 is a sectional view showing a basic structure of a solid-state image pickup device according to a second embodiment of the present invention, Fig. 7 is a sectional view showing a basic structure of a solid-state image pickup device according to a third embodiment of the present invention, Fig. 8 is a sectional view showing a basic structure of a solid-state image pickup device according to a fourth embodiment of the present invention, Fig. 9 is a plan view of a flare preventive plate of the solid-state image pickup device shown in Fig. 8, Fig. 10 is a perspective view of a mold, Fig. 11 is a side sectional view of the mold of Fig. 10 taken along the line 11 -11 thereof, Fig. 12 is a plan view of a base of the mold of Fig. 10, Figs. 13 to 16 are sectional views sequentially showing the steps in manufacturing the solid-state image pickup device, Fig. 17 is a sectional view showing another mold, Fig. 18 is a perspective view of a glass plate, Fig. 19 is a representation for explaining application of a mold release agent for the glass plate, and Fig. 20 is a representation for explaining drying of the mold release agent coated on the glass plate.

Fig. 1 shows a solid-state image pickup device conceived by the inventor. Solid-state image pickup device 1 is made of a synthetic resin. Both end faces of package 2 have an arcuated shape, and both side faces thereof have a linear shape. Rectangular recess 3 is formed in the upper surface portion of package 2. Semiconductor chip 4 is mounted and fixed in recess 3. Recess 3 has open ends at side faces of package 2. Dimensions of chip 4 are slightly smaller than those of recess 3 except for the height. Image pickup surface 5 is constituted by the upper surface of chip 4. A level of upper surfaces 6, at two ends of package 2 defining recess 3, is substantially the same as surface 5. A plurality of lead legs 7 extend from the lower surface of package 2. Lead wires 8 extending from chip 4 are guided toward two ends of package 2 and are electrically connected to legs 7, respectively.

As shown in Figs. 2 and 3, a plurality of guide grooves 9 are formed at both ends of package 2 and are spaced apart from each other. Grooves 9 extend from surface 6 to end face 11 of package 2. Conductive layer 12 of a metal (gold)-plated member is fitted in each groove 9. Layer portions at both end faces of package 2 are recessed from the surfaces of both ends of package 2. One end of each layer 12 is extended to the under face of package 2 and electrically connected to a corresponding one of legs 7. The other end of each layer 12 is electrically connected to a corresponding one of wires 8.

The upper surface of package 2 including chip 4 is covered with transparent resin layer 13 of a transparent protective member, e.g., epoxy resin, without forming a space therebetween. More specifically, the upper surface and both side surfaces of chip 4 including surface 5 are sealed. At the same time, the space between the end inner faces of recess 3 and both ends of chip 2 is also sealed with resin layer 13. Furthermore, top surfaces 6 at both ends of package 2 are covered and sealed. The resin is also injected in grooves 9 so that layers 12 are covered by extended portions 13A of layer 13.

Side surface level of layer 13 is the same as that of package 2. Incident surface 14 as an outer surface of layer 13 is parallel to surface 5 of chip 4.

Fig. 4 shows a basic sectional structure of device 1.

According to the arrangement described above, since the upper surfaces including surface 5 of chip 4 and package 2 are covered and sealed, a separate protective member need not be mounted at the peripheral portion of package 2. For this reason, an outer diameter along a direction parallel to surface 5 can be decreased.

Fig. 5 shows a first embodiment of the present invention. In this embodiment, transparent resin layer 13 is constituted by two layers. More specifically, layer 13 consists of first transparent resin layer 21, covering and sealing the upper surfaces including surface 5 of chip 4 and package 2, and second transparent resin layer 22 covering layer 21. With this arrangement, layer 21 protects chip 4. In this sense, high precision is not required for layer 21. Surface 14 of layer 22 is formed with high precision in the same manner as in the first embodiment. The resin of layer 22 has good resistance to the atmosphere. According to this embodiment, layer 21 can be easily formed.

Fig. 6 shows a second embodiment of the present invention. The transparent resin layer is constituted by two layers in the same manner as in the first embodiment. However, unlike in the first embodiment, first transparent resin layer 21 is arcuated and is not parallel to image pickup surface 5.

Fig. 7 shows a third embodiment of the present invention. A transparent plate 25 such as a glass plate having flat upper and lower surfaces is formed on transparent resin layer 13. The horizontal cross-sectional shape of plate 25 is the same as those of package 2 and layer 13.

Fig. 8 shows a fourth embodiment of the present invention. The transparent resin layer 14 is constituted by two layers 21, 22 in the same manner as in the first embodiment. However, unlike the first embodiment, flare preventive plate 26 of with a rectangular window 27 is inserted at a boundary between first transparent resin layer 21 and second transparent resin layer 22. Plate 26 has a shape shown in Fig. 9. A light image vertically incident on surface 14 is guided to surface 5 through window 27. Light rays incident outside this normal incident path are shielded by plate 26 and are not incident on surface 5, thereby preventing the flare phenomenon. In particular, when device 1 is inserted into and supported by a pipe-like holding frame (not shown), light rays reflected by the inner surface of the support frame can also be shielded.

Methods of manufacturing devices 1 will be described. First, a method of manufacturing device 1 of Figure 1 will be described. Before such a description, a mold 30 shown in Figs. 10 to 12 will be described. A pair of right and left mold halves 32 are detachably mounted on an upper surface of a base 31. Two recesses 34 of surface 33 of right mold half 32 are formed at positions corresponding to recesses 34 of surface 33 of left mold half 32, thereby constituting two molding cavities 35. Guide holes 37 are formed in right and left mold halves 32, respectively. Guide pins 36 are to be inserted in corresponding guide holes 37. As shown in Fig. 12, pins 36 are vertically extended from the upper surface of base 31. When mold halves 32 are set in a closed state onto base 31, pins 36 are fitted in holes 37 to set mold halves 32 in position. Mold halves 32 are fixed by screws 38 at predetermined positions on base 31. As shown in Fig. 12, escape holes 39 are formed in the upper surface of base 31 at a location corresponding to cavities 35, so that legs 7 of device 1 can be inserted in holes 39.

Device 1 of Figure 1 is manufactured according to the following steps. Mold 30 is assembled, and grease is applied to the bottom surface of each cavity 35 constructed by the upper surface of base 31. A mold release agent is applied to side wall surfaces of each cavity 35 (the mold release agent may be applied to the entire surface of cavity 35). Mold 30 is placed on a hot plate and heated to a temperature at which chip 4 will not be damaged by heat, preferably about 80°C. Thereafter, as shown in Fig. 13, package 2 with chip 4 fixed thereon is placed in cavity 35. In this case, legs 7 are respectively inserted in holes 39. The side surfaces of package 2 are brought into tight contact with the wall surfaces of cavity 35, such that spaces are formed between the wall surfaces and portions corresponding to grooves 9.

When package 2 is respectively set in cavity 35, transparent resin 41 such as epoxy resin in a fluid state is poured, as shown in Fig. 14. The upper surface of resin 41 slightly extends upward from the upper surface of cavity 35.

A glass plate 42 with a flat lower surface as a forming member, shown in Fig. 18, is pressed on the extended portion from the opening of each cavity 35 to flatten the upper surface of resin 41, as shown in Fig. 16. In this case, plate 42 covers the entire area of the opening of each cavity 35 and at the same time abuts against the upper surface of mold 30. Since the upper surface of mold 30 is parallel to image pickup surface 5 of chip 4, the upper surface of resin 41 is also parallel to surface 5. Excess resin 41 overflows from cavity 35 and is horizontally moved to constitute burrs. A mold release agent is applied to at least a portion of plate 42 which is to be brought into contact with the upper surface of resin 41. This mold release treatment is necessary since plate 42 tends to be adhered to resin 41. This treatment will be described later.

After this process, resin 41 is dried and cured. For example, resin 41 is exposed at a temperature of 88°C for about 16 hours.

After drying and curing, screws 38 are removed, and pins 36 are moved downward into base 31. Only mold halves 32 are horizontally removed while plate 42 is held on the upper surface of resin 41, as shown in Fig. 16.

Plate 42 is removed, and burrs are then removed from resin 41. Device 1 is removed from mold 30.

In the fabrication process of devices 1 of the first and second embodiments of the inventions, before or after each package 2 is placed in corresponding cavity 35, resin is coated or poured in cavity 35 to form layer 21. In the fabrication process of device 1 of the fourth embodiment, plate 26 is fitted in cavity 35 before resin of layer 21 is cured. Thereafter, a resin for layer 22 is poured in cavity 35. Other steps are the same as those in the fabrication process of device 1 of the first embodiment.

A VYDAX-AR (RTM) can be used as a mold release agent to be coated on the wall surfaces of cavity 35. The CYDAX-AR is a white short-chained tetrafluoroethylene telomer dispersed in a solvent of trichlorotrifluoroethane ($CCL_2F - CCLF_2$) and is available from E. I. DuPont De Nemours & Co. This mold release agent can be simply applied to the wall surfaces of cavity 35. However, if the agent is baked, its durability can be improved. Hot air of 299°C to 316°C is blown on the mold release agent for 20 minutes for baking.

Plate 42 is released from resin 41 in the following manner. Plate 42 shown in Fig. 18 is cleaned with an ultrasonic wave. Plate 42 is then dipped in treatment agent 50, as shown in Fig. 19. Plates 42 are then baked in a heating furnace 51 shown in Fig. 20. Agent 50 may be a teflon- or silicone-based agent. A silicone-based agent is exemplified by a mixture of xylene and KS700 (available from Shinetsu Silicon KK) at a ratio (% by weight) of 2 : 3. Plates 42 are exposed in furnace 51 at a temperature of 220°C to 260°C for one to three hours. Preferably, plates 42 are baked at a temperature of 240°C for 2 hours. The baking process need not be performed, but can improve durability.

The forming member is not limited to a glass forming member. When a transparent forming member is used, a resin state (generation of bubbles) can be monitored, thus preventing operation failure. If the forming member has a flat resin contact surface, the member need not be a plate-like member.

Fig. 17 shows a modification of mold 30. Cavity 35 is formed in base 31 of mold 30. Resin injection holes 61 are formed in the side walls of mold 30 to communicate with the cavity 35. In the process for injecting resin in cavity 35, the opening of cavity 35 is covered with glass plate 42 in advance. A transparent resin is injected from one hole 61 to fill cavity 35 with compressed resin. Hole 62 is formed in the bottom wall of cavity 35. A pin or the like is inserted in hole 62 to push on the finished device for removing it from mold 30.

In the fabrication of the third device 1, after a transparent resin is injected in cavity 35, a glass plate (without mold release treatment) with a size corresponding to that of cavity 35 is fitted in cavity 35. This glass plate is adhered to the resin. The resultant structure is dried and cured, and the finished device is removed.

The mold is not limited to a metal mold, but can be constituted by a mold with some elasticity. Contact precision between the package and the elastic mold is better with such an elastic mold.

According to the present invention as described above, the dimensions of the image pickup device along an image pickup surface direction can be reduced, and the structure of the device can be simplified. The upper surface of the solid-state image pickup device including the image pickup surface is sealed, and thus durability of the device can be improved. Such a solidstate image pickup device can be easily and systematically fabricated.

## Claims

1. A solid-state image pickup device comprising a semiconductor chip (4) having an image pickup surface (5), a package (2) on which said semiconductor chip (4) is fixed, and a transparent protective member (13) for protecting the image pickup surface (5) of said semiconductor chip (4) and guiding a light image onto the image pickup surface (5), characterized in that said transparent protective member (13) includes a first transparent resin layer (21) covering at least the image pickup surface (5) without forming a space therebetween, and a second transparent resin layer (22) covering an upper surface of said first transparent resin layer (21) and having an incident surface (14) formed parallel to the image pickup surface, said first and second transparent resin layers (21, 22) being coextensive with the top surface (6) of the package (2).

2. A solid-state image pickup device comprising a semiconductor chip (4) having an image pickup surface (5), a package (2) on which said semiconductor chip (4) is fixed, and a transparent protective member (13) for protecting the image pickup surface (5) of said semiconductor chip (4) and guiding a light image onto the image pickup surface (5), characterized in that said transparent protective member (13) includes a first transparent resin layer (21) covering at least the image pickup surface (5) without forming a space therebetween and a transparent plate (25) covering an upper surface of said first transparent resin layer (21) and having an incident surface (14) formed parallel to the image pickup surface (5), said first transparent resin layer (21) and said transparent plate (25) being coextensive with the top surface (6) of the package (2).

3. A device according to 1 or 2, characterized in that the package (2) is provided with a recess (3) formed in the top face, wherein the semiconductor chip (4) is received.

4. A method of manufacturing a solid-state image pickup device, comprising the steps of : placing a package (2) with a semiconductor chip (4) in a molding cavity (35) of a mold (30) such that an image pickup surface (5) of said semiconductor chip (4) is directed toward an opening of the molding cavity (35) and the size of the molding cavity (35) is adapted to the size of the package (2) so that the peripheral walls of the package are in contact with the side walls of the molding cavity (35) ; pouring a transparent resin (41) in a fluid state in the molding cavity (35) ; curing the fluid resin to form a first transparent resin layer (21) ; pouring a second transparent resin (41) in a fluid state in the molding cavity (35) ; bringing a forming member (42) onto said second transparent resin (41) in the molding cavity (35) to set an incident outer surface (14) of said second transparent resin (41) to be parallel to the image pickup surface (5) of said semiconductor chip (4) ; curing said second transparent resin (41) in the fluid state to form a second transparent resin layer (22) ; and releasing said forming member (42) after the curing step.

5. A method according to claim 4, characterized in that at least a surface of said forming member (42) which is to be brought into contact with said second transparent resin (41) is treated with a mold release agent.

6. A method according to claim 4, characterized in that at least a surface of said forming member (42) which is to be brought into contact with said second transparent resin (41) is treated with a silicone-based mold release agent.

7. A method of manufacturing a solid-state image pickup device, comprising the steps of : placing a package with a semiconductor chip (4) in a molding cavity (35) of a mold (30) such that an image pickup surface (5) of said semiconductor chip (4) is directed toward an opening of the molding cavity (35) and the size of the molding cavity (35) is adapted to the size of the package (2) so that the peripheral walls of the package are in contact with the side walls of the molding cavity (35) ; pouring a transparent resin (41) in a fluid state in the molding cavity (35) ; bringing a transparent plate (42) having a size corresponding to that of molding cavity (35) onto contact with the upper surface of the transparent resin (41) in the molding cavity (35) and setting an incident outer surface (14) of said transparent plate (42) to be parallel to the image pickup surface (5) of said semiconductor chip (4) ; and curing the transparent resin (41) in the fluid state after the contacting step so that transparent plate (42) is adhered flush to the transparent resin (41).

8. A method according to claim 7, characterized in that said transparent plate comprises a glass plate (42) with a flat lower surface.

## Ansprüche

1. Halbleiter-Bildaufnahmevorrichtung mit einem Halbleiter-Chip (4) mit einer bildaufnehmenden Oberfläche (5), einem Gehäuse (2), auf dem der Halbleiter-Chip (4) befestigt ist, und einem transparenten Schutz (13), **dadurch gekennzeichnet,** daß der transparente Schutz (13) eine erste transparente Kunststoffschicht (21), die wenigstens die bildaufnehmende Oberfläche (5) abdeckt, ohne einen Zwischenraum zu bilden, und eine zweite transparente Kunststoffschicht (22) aufweist, die die obere Oberfläche der ersten transparenten Kunststoffschicht (21) bedeckt und eine Einfallsfläche (14) aufweist, die parallel zur bildaufnehmenden Oberfläche ausgebildet ist, wobei die erste und zweite transparente Kunststoffschicht (21, 22) die gleiche Ausdehnung wie die obere Oberfläche (6) des Gehäuses (2) aufweisen.

2. Halbleiter-Bildaufnahmevorrichtung mit einem Halbleiter-Chip (4) mit einer bildaufnehmenden Oberfläche (5), einem Gehäuse (2), auf dem der Halbleiter-Chip (4) befestigt ist und einem transparenten Schutz (13), der zum Schutz der bildaufnehmenden Oberfläche (5) des Halbleiter-Chips (4) und zum Leiten eines optischen Bildes auf die bildaufnehmende Oberfläche (5) dient, dadurch gekennzeichnet, daß der transparente Schutz (13) eine erste transparente Kunststoffschicht (21), die wenigstens die bildaufnehmende Oberfläche abdeckt, ohne einen Zwischenraum zu bilden, und eine transparente Platte (25) aufweist, die eine obere Oberfläche der ersten Kunststoffschicht (21) abdeckt und eine Einfallsfläche (14) aufweist, die parallel zu der bildaufnehmenden Oberfläche (5) ausgebildet ist, wobei die erste transparente Kunststoffschicht (21) und die transparente Platte (25) die gleiche Ausdehnung wie die obere Oberfläche (6) des Gehäuses (2) aufweisen.

3. Vorrichtung nach Anspruch 1 oder 2, dadurch gekennzeichnet, daß das Gehäuse (2) mit einer Ausnehmung (3) in der oberen Oberfläche versehen ist, die den Halbleiter-Chip (4) aufnimmt.

4. Verfahren zur Herstellung einer HalbleiterBildaufnahmevorrichtung mit folgenden Verfahrensschritten : Einbringung eines Gehäuses (2) mit einem Halbleiter-Chip (4) in einen Gieß-Hohlraum (35) einer Gießform (30) so, daß eine bildaufnehmende Oberfläche (5) des Halbleiter-Chips (4) zur Öffnung des Gieß-Hohlramus (35) gerichtet ist und die Größe des Gieß-Hohlraums (35) an die Größe des Gehäuses (2) angepaßt ist, so daß die Umfangswände des Gehäuses im Kontakt mit den Seitenwänden des Gieß-Hohlraums (35) sind ; Eingießen eines transparenten Kunststoffs (41) im flüssigen Zutand in den Gieß-Hohlraum (35) ; Aushärten des flüssigen Kunststoffs zur Bildung einer ersten transparenten Kunststoffschicht (21) ; Eingießen eines zweiten transparenten Kunststoffs (41) im flüssigen Zustand in den Gieß-Hohlraum (35) ; Einbringen eines Formteils (42) auf den zweiten transparenten Kunststoff (41) in den Gieß-Hohlraum (35) zur Ausbildung einer äußeren Einfallsfläche (14) des zweiten transparenten Kunststoffs (41) parallel zur bildaufnehmenden Oberfläche (5) des Halbleiter-Chips (4) ; Aushärten des zweiten transparenten Kunststoffs (41) im flüssigen Zustand zur Ausbildung einer zweiten transparenten Kunststoffschicht (22) ; Entfernen des Formteils (42) nach dem Aushärtungsschritt.

5. Verfahren nach Anspruch 4, dadurch gekennzeichnet, daß wenigstens eine Oberfläche des Formteils (42), die mit dem zweiten transparenten Kunststoff (41) in Kontakt gebracht werden soll, mit einem Gieß-Trennmittel behandelt wird.

6. Verfahren nach Anspruch 4, dadurch gekennzeichnet, daß wenigstens eine Oberfläche des Formteils (42), die mit dem zweiten transparenten Kunststoff (41) in Kontakt gebracht werden soll, mit einem Gieß-Trennmittel auf einer Silikon-Basis behandelt wird.

7. Verfahren zur Herstellung einer HalbleiterBildaufnahmevorrichtung mit folgenden Verfahrensschritten : Einbringen eines Gehäuses mit einem Halbleiter-Chip (4) in einen Gieß-Hohlraum (35) einer Gießform (30) so, daß die bildaufnehmende Oberfläche (5) des Halbleiter-Chips (4) zur Öffnung des Gieß-Hohlraums gerichtet ist und die Größe des Gieß-Hohlraums (35) an die Größe des Gehäuses (2) angepaßt ist, so daß die Umfangswände des Gehäuses im Kontakt mit den Seitenwänden des Gieß-Hohlraums (35) sind ; Eingießen eines transparenten Kunststoffs (41) im flüssigen Zustand in den Gieß-Hohlraum (35) ; Inkontaktbringen einer transparenten Platte (42), deren Größe mit der des Gieß-Hohlraums (35) übereinstimmt, mit der oberen Oberfläche des transparenten Kunststoffs (41) in dem Gieß-Hohlraum (35) und Ausrichtung einer äußeren Einfallsfläche (14) der transparenten Platte (42) parallel zu der bildaufnehmenden Oberfläche (5) des Halbleiter-Chips (4) ; und Aushärten des transparenten Kunststoffs (41) im flüssigen Zustand nach der Kontaktierung, so daß die transparente Platte (42) fluchtend an dem transparenten Kunststoff (41) haftet.

8. Verfahren nach Anspruch 7, dadurch gekennzeichnet, daß die transparente Platte eine Glasplatte mit einer ebenen unteren Oberfläche aufweist.

**Revendications**

1. Dispositif de prise d'images à semi-conducteur comportant une pastille de semi-conducteur (4) ayant une surface de prise d'images (5), un boîtier (2) sur lequel est fixée ladite pastille de semi-conducteur (4) et un élément protecteur transparent (13) pour protéger la surface de prise d'images (5) de ladite pastille de semiconducteur (4) et pour guider une image lumineuse sur la surface de prise d'images (5), **caractérisé** en ce que ledit élément protecteur transparent (13) comporte une première couche de résine transparente (21) couvrant au moins la surface de prise d'images (5) sans former un espace entre celles-ci, et une deuxième couche de résine transparente (22) couvrant une surface supérieure de ladite première couche de résine transparente (21) et ayant une surface incidente (14) formée parallèlement au dispositif de prise d'images, lesdites première et deuxième couches de résine transparente (21, 22) s'étendant conjointement avec la surface supérieure (6) du boîtier (2).

2. Dispositif de prise d'images à semi-conducteur comprenant une pastille de semi-conducteur (4) ayant une surface de prise d'images (5), un boîtier (2) sur lequel est fixé ladite pastille de semi-conducteur (4), et un élément protecteur transparent (13) pour protéger la surface de prise d'images (5) de ladite pastille de semiconducteur (4) et pour guider une image lumineuse sur la surface de prise d'images (5), **caractérisé** en ce que ledit élément protecteur transparent (13) comporte une première couche de résine transparente (21) couvrant au moins la surface de prise d'images (5) sans former un espace entre celle-ci et une plaque transparente (25) couvrant une surface supérieure de ladite première couche de résine transparente (21) et ayant une surface incidente (14) formée parallèlement à la surface de prise d'images (5), ladite première couche de résine transparente (21) et ladite plaque transparente (25) s'étendant conjointement à la surface supérieure (6) du boîtier (2).

3. Dispositif selon la revendication 1 ou 2, **caractérisé** en ce que le boîtier (2) est muni d'une cavité (3) formée dans la face supérieure, dans laquelle est reçue la pastille de semi-conducteur (4).

4. Procédé pour fabriquer un dispositif de prise d'images à semi-conducteur, comportant les étapes suivantes : disposition d'un boîtier (2) avec une pastille de semi-conducteur (4) dans une cavité de moulage (35) d'un moule (30) de telle sorte qu'une surface de prise d'images (5) de ladite pastille de semi-conducteur (4) soit dirigée vers une ouverture de la cavité de moulage (35) et que la taille de la cavité de moulage (35) soit adaptée à la taille du boîtier (2), de telle sorte que les parois périphériques du boîtier soient en contact avec les parois latérales de la cavité de moulage (35) ; versage d'une résine transparente (41) dans état fluide dans la cavité de moulage (35) ; durcissage de la résine fluide afin de former une première couche de résine transparente (21) ; versage d'une deuxième résine transparente (41) dans un état fluide dans la cavité de moulage (35) ; disposition d'un élément de formage (42) sur ladite deuxième résine transparente (41) dans la cavité de moulage (35) pour déterminer une surface extérieure incidente (14) de ladite deuxième résine transparente (41) de façon à ce qu'elle soit parallèle à la surface de prise d'images (5) de ladite pastille de semi-conducteur (4) ; durcissage de ladite deuxième résine transparente (41) dans l'état fluide afin de former une deuxième couche de résine transparente (22) ; et retrait dudit élément de formage (42) après l'étape de durcissage.

5. Procédé selon la revendication 4, **caractérisé** en ce qu'au moins une surface dudit élément de formage (42) qui doit être mis en contact avec ladite deuxième résine transparente (41) est traitée avec un agent de retrait de moule.

6. Procédé selon la revendication 4, **caractérisé** en ce qu'au moins une surface dudit agent de formage (42) qui doit être mis en contact avec ladite deuxième résine transparente (41) est traitée avec un agent de retrait de moule à base de silicone.

7. Procédé de fabrication d'un dispositif de prise d'images à semi-conducteur, comportant les étapes suivantes : disposition d'un boîtier avec une pastille de semi-conducteur (a) dans une cavité de moulage (35) d'un moule (30) de telle sorte que la surface de prise d'images (5) de ladite pastille de semi-conducteur (4) soit dirigée vers une ouverture de la cavité de moulage (35) et que la taille de la cavité de moulage (35) soit adaptée à la taille du boîtier (2) de telle sorte que les parois périphériques du boîtier soient en contact avec les parois latérales de la cavité de moulage (35) ; versage d'une résine transparente (41) dans un état fluide dans la cavité de moulage (35) ; disposition d'une plaque transparente (42) ayant une taille correspondant à celle de la cavité de moulage (35) en contact avec la surface supérieure de la résine transparente (41) dans la cavité de moulage (35) et établissement d'une surface extérieure incidente (14) de ladite plaque transparente (42) de façon à ce qu'elle soit parallèle à la surface de prise d'images (5) de ladite pastille de semi-conducteur (4) ; et durcissage de la résine transparente (41) dans l'état fluide après l'étape de mise en contact, de telle sorte que la plaque transparente (42) adhère à la résine transparente (41) au même niveau que celle-ci.

8. Procédé selon la revendication 7, **caractérisé** en ce que ladite plaque transparente comporte une plaque de verre (42) avec une surface inférieure plate.

F I G. 1

F I G. 2

F I G. 3

# F I G. 4

# F I G. 5

# F I G. 6

# F I G. 7

# F I G. 8

# F I G. 9

9

F I G. 10

F I G. 11

30
34
33
38
35
32
38
32
36
37
34
II
37
36
37
34
35
38
34
38
31

32
35
30
32
39
39
31

F I G. 12

39
39
31
36
36
39

F I G. 13

F I G. 14

35
8
4
32
32
2
7
7

32
41
5
4
32
30
2
31
7
7

10

# F I G. 15

# F I G. 16

# F I G. 17

# F I G. 18

# F I G. 19

# F I G. 20